# EUROPEAN PATENT SPECIFICATION

(11) **EP 4 295 417 B1**
(45) Date of publication and mention of the grant of the patent: **21.05.2025**
(21) Application number: 22922737.6
(22) Date of filing: 27.01.2022
(51) Int. Cl.: H10F 19/30, H10F 71/00, H10F 77/20

(54) **METHOD FOR FORMING CRISSCROSSED CONDUCTIVE LINES OF THIN-FILM SOLAR MODULE**
VERFAHREN ZUR HERSTELLUNG VON KREUZFÖRMIGEN LEITERBAHNEN EINES DÜNNSCHICHTSOLARMODULS
PROCÉDÉ DE FORMATION DE LIGNES CONDUCTRICES ENTRECROISÉES DE MODULE SOLAIRE A FILM MINCE

(43) Date of publication of application: 27.12.2023
(73) Proprietor: Triumph Science & Technology Group Co., Ltd, Beijing 100036 (CN); CNBM RESEARCH INSTITUTE FOR ADVANCED GLASS MATERIALS GROUP CO., LTD, Bengbu, Anhui 233010 (CN)
(72) Inventor: SHEN, Yilei, 81739 Munich (DE); GADDIGOPULA, Bala-Krishna, 81739 Munich (DE)
(74) Representative: Staeger & Sperling Partnerschaftsgesellschaft mbB
(86) International application number: PCT/CN2022/074362
(87) International publication number: WO 2023/141891

(56) References cited:
- WO-A1-2019/224007
- CN-A- 108 831 627
- CN-B- 105 489 666
- US-A1- 2012 051 508
- US-A1- 2012 132 271
- US-A1- 2012 231 576
- US-A1- 2014 262 456

## Description

### Technical Field

This disclosure relates to a technical field of solar energy, and in particular to a method for forming crisscrossed conductive lines of a thin-film solar module.

### Background

In general, a thin-film solar cell consists of a back electrode layer, an absorber layer, a buffer layer/i-layer, and a front electrode layer in sequence. Due to low voltage and large area of the cell, most thin-film solar modules are designed to inter-connect their individual solar cells in monolithic series, in order to avoid high current losses. However, it will increase the total operation voltage in the solar modules.

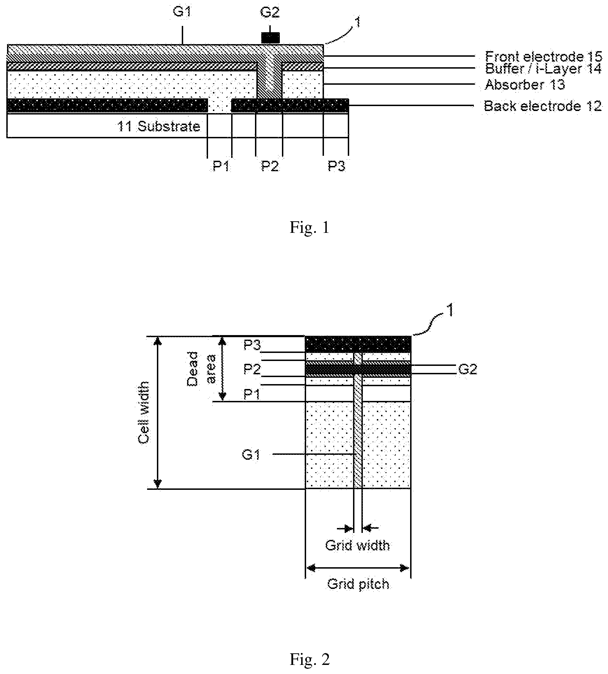

The individual layers in the cell are interconnected, as shown in Fig.1. These layers are separated by P1, P2 and P3 structuring lines, respectively. The P1 structuring line and P3 structuring line insulate the back electrode layer and the front electrode layer, and the P2 structuring line serves as an electrical contact between the back electrode layer and the front electrode layer for serial connection of two neighboring cells. Since the structuring area of the P1, P2 and P3 structuring lines does not generate electricity, it usually refers to as the "dead area", see Fig. 2.

To optimize the power conversion efficiency of the solar cell, one approach is often considered, e.g. increasing the transmission of the front electrode layer of the solar cell by reducing the thickness of the front electrode layer and further the photo current generated. However, it will lead to an increase in the sheet resistance of the front electrode layer, causing ensuing conduction losses. To reduce such conduction losses in the front electrode layer, highly conductive narrow metal grid lines (which are referred to as the first type of grid lines) can be applied on the front electrode layer to improve related electrical conductivity, which refers to as a metallization process in the solar module production. In the metallization process, the first type of grid lines are deposited transversely on the top of the front electrode layers of the solar cells or perpendicular to the P1/ P2/P3 structuring lines at periodic intervals. Further, the first type of grid lines are deposited continuously over the front electrode layers of the solar cells. The P3 structuring line interrupts the first type of grid lines to prevent a short circuit between the front electrodes of one cell and its neighboring cell.

The first type of grid lines can reduce the conduction losses of the front electrode layer. However, the grid lines also lead to an increase in the dead area due to the shading of the grid lines, and further cause additional optical losses. Besides, the application of the first type of grid lines also can lead to a concentrated current at an end of a cell. In the case of a monolithic interconnected cell, the current collected at the first type of grid lines flows to an end of the cell and needs to be evenly distributed at the beginning of the next cell. Otherwise, further conduction losses in the front and back electrode layers will arise.

Therefore, an additional grid line, which is referred to as the second type of grid line, is deposited within the dead area and perpendicular to the first type of grid lines. Here, the first type of grid line is denoted as G1, and is perpendicular to the P2 structuring line; the second type of grid line is denoted as G2, and is deposited exactly on the P2 structuring line or parallel to the P2 structuring line. The intention of depositing the G2 grid line is to evenly distribute the current and reduce electrical loss along P2 structuring line interconnect between two G1 grid lines, which is caused by current distribution from the G1 grid lines raised at the beginning of the next cell. Since the G2 gird line is placed in the dead area, it will not cause additional optical loss by shading. Besides, the G2 grid line can improve the generation of photo current, which is contributed to the light reflection at the G2 grid line onto the back of the over layer/front glass and further into the active cell area.

Therefore, the precise deposition of the G2 grid line is needed regarding the exact electrical and optical management in the dead area. In addition, when G2 crosses the P3 line edges, it might cause shunts. When G2 crosses the below line edge of P1 (in the Fig.2), it will cause optical loss in the active area.

Concerning the mass production of thin-film solar modules using metal grid lines (G1 and G2 grid lines) for the enhancement of front contact, there is generally a need for a manufacture process of low CAPEX cost, short circle time and high production throughput. In addition, the metal grid lines (G1 and G2 grid lines) need to be deposited in two totally different directions of 0° and 90°. To realize it, additional accurate handling/alignment aggregates are required to change a printing/machine direction, or the double number of printing and conveyor units are required to complete the deposition of G1 and G2 grid lines. Thus, it will increase the CAPEX cost and production circle time. Additionally, possible misalignment during rotation/handling of the thin-film solar module will also lead to wrong positioning of the G2 grid line.

In the prior art, commercial thin-film/CIGS photovoltaic manufacturers (Solibro Hi-Tech GmbH / Beijing Apollo Ding Rong Solar Technology Co., Ltd) or (NICE Solar Energy GmbH) and its related research institutions (National Institute of Clean-and-Low-Carbon Energy, Department of Mechanical Engineering of Tsinghua University Beijing) presented their methods to deposit metal grid lines on the front electrode layers of CIGS modules.

Solibro Hi-Tech GmbH provides a method referred to as ALD (Aluminum Line Deposition) method, which is to deposit an aluminum conductive line structure through a mask via a thermal evaporation method. Various drawbacks in this method are 1) low production throughput and yield by using mask, 2) high cost of such special mask for the production of large area module, 3) high material waste due to evaporation, 4) high maintenance efforts for masks, 5) limitation in the widths of metal grid lines (too narrow mask opening, less than several hundred micrometers, will be easily clogged during/after usage). All these drawbacks mentioned above are relevant for deposition of general metal grid lines, mostly G1 grid lines. If the thermal evaporation method is used for the deposition of the G2 grid lines, it could be expected that the G1 and G2 grid lines will be very difficult to be deposited simultaneously due to shadowing effect.

Nice Solar Energy GmbH uses a screen printing method to deposit the G1 grid lines, and uses an e-beam evaporation method to deposit the G2 grid lines. The screen printing method is not suitable to be used to print the G1 grid lines on large area solar module, since it has the following critical technical limitation. The larger the printing pattern is, the less deposition accuracy and line shape of the G1 grid lines will be kept in the middle region of the large printing area (e.g. >1m²) due to less stiffness of the large screen mesh in the center. Also, the printing of narrow gird lines by the screen printing method will require a high quality screen mesh, e.g. hardened stainless steel mesh calendered, or knotless screen mesh. For the full size thin-film solar module (e.g. >1m²), those high quality screen meshes of large size are very difficult to be manufactured and extremely expensive. And, a screen mesh for printing the grid lines is prone to be clogged and difficult to be cleaned. Usually, a Si-PV (6"×6") screen mesh will be scrapped after certain printing processes without cleaning. In addition to high cost of using screen printing method for large thin-film modules, it is also quite inflexible to change the printing pattern of grid lines, in case that the line pitch of the grid line need be adjusted for production samples.

Furthermore, there is the following drawback in deposition of G2 grid lines by the screen printing method. In the case of printing G1 grind lines and G2 grid lines simultaneously, the deposition accuracy and line widths of the G2 grid lines are very limited, since the stiffness of screen mesh is difficult to be kept in both direction (0° and 90°) due to opening. Loss in the stiffness of screen mesh causes the decrease in the deposition accuracy of the G2 grid lines and the broadening in the widths of the G2 gird lines. Accordingly, printed grid lines may be S-shaped. As mentioned before, the optimal deposition of G2 grid lines means that the G2 grid lines is placed very precisely in the dead area close to the P2 structuring lines and is not be placed across the edges of the P1 and P3 structuring lines. Otherwise, the G2 grid lines will create additional optic losses in the active cell area or shunts. Since the thin-film solar modules in production have a very process window for P2 structuring lines, there is large variation in the line pitch and shape of the P2 structuring line. Due to inherent inflexible printing strategy of the screen printing method, it is almost impossible to do quick adjustment in the production. In another case of two-step printing of G1 and G2 grid lines, in which the G2 grid line are printed after the G1 grid lines are printed, other issues are encountered. Unlike double-printing (used in Si-PV to deposit 2-layer prints to increase the heights of G1 grid lines), not-cured and soft G1 grid lines will be easily ruined by the squeegee during printing G2 grid lines in the direction of 90°. In the case that the G1 grid lines are first printed and cured, and then the G2 gird lines are printed and cured, there are two curing processes for the G1 and G2 grid lines. Thus, the thin-film solar module might be damaged due to overshoots of thermal energy. And, two printing and curing processes will also increase the CAPEX and OPEX cost.

In addition to the conventional screen printing method, there is also an alternative rotary screen printing method for the deposition of the conductive grid lines, which is only suitable for Si-PV (6"×6" wafers). For the large-area thin-film solar module, the rotary screen printing method has the drawbacks similar to the conventional screen printing method. For large printing width (600~1300mm), the selected rotary tube material is difficult to keep the sufficient stiffness so that the deposition accuracy and width of the grid lines will be strongly affected. In the worst case, the grid lines in the middle region of the entire solar module will be S-shaped.

Furthermore, the e-Beam evaporation process for printing the G2 gird lines, as reported by Nice Solar Energy GmbH, is only suitable for the lab-scale, but not for mass production, since it is a full-area coating process. Such a method will possess the drawbacks and limitations similar to the thermal evaporation method, e.g., mainly low production throughput and high cost.

In the prior art, there are other process methods, such as an aerosol jet printing method, a dispensing method, which are quite new technologies for the metallization process, and still have strong process stability issues. The nozzles of aerosol jet and dispenser are prone to be clogged by metal particles during long-term printing, which leads to frequent process downtime. In addition, the upscale of these two methods is still in the early development. The maximum number of grid lines (G1) that can be printed simultaneously is 5~10. For the large-area thin-film solar module (which may have up to 1000 G1 grid lines and few hundred G2 grid lines), many printing passes are required, i.e. very low throughput is currently encountered for the aerosol jet printing method. Further increase in the number of nozzles for dispensing or aerosol jetting is not easy as the numbering-up route for inkjet printing, since the paste/aerosol distribution along the horizontal direction in the printing head is extremely challenging. At present, 10 nozzles are almost the bottle-neck for both technologies. Furthermore, it is only possible to deposit the G2 grid lines in the direction perpendicular to the G1 grid lines by changing the machine/printing direction for the dispensing and aerosol jetting methods.

Furthermore, there are some other metallization methods. In these methods, the conventional inkjet printing technology is used to apply metal grid lines on thin-film organic PV modules or Si-solar modules. In these metallization methods, inkjet printing was used to apply straight grid lines (that is, G1 grid lines). This kind of linear pattern formation is only realized by overlap of droplets jetted by the same nozzle in one printing direction. However, in the process of printing the G2 gird lines, it is necessary to rotate the solar module to print the G2 grid lines in the direction perpendicular to the direction of printing the G1 grid lines. Further, jetted droplets for G2 grid lines have a spacing of few hundred micrometers and thus cannot be connected in the direction perpendicular to the direction of printing the G1 grid lines. As conclusion, these conventional inkjet printing strategies cannot fulfill the mass production requirements of low circle time and high throughput without additional rotation/handling to print G1 and G2 grid lines.

Various inkjet metallization production tools have been presented in the prior art. However, they either focus on Si-PV (6"×6") wafer, or linear inline printing process integration for flexible thin-film devices. In these inkjet metallization production tools, inkjet printing of linear pattern for G1 grid lines is possible in the large-area thin-film solar module by numbering-up of print heads or multi-step printing. However, for G2 grid lines, these inkjet metallization production tools will change the printing/machine direction to print the G2 grid lines. Therefore, these inkjet metallization production tools cannot fulfill the mass production requirements of low circle time and high throughput without additional rotation/handling to print the G1 and G2 grid lines.

Therefore, there is a need for a method and inkjet printer for depositing G1 and G2 grid lines in one printing/machine direction, so as to fulfill the mass production requirements of low circle time and high throughput without additional rotation/handling to print the G1 and G2 grid lines, and the requirements of good line width control, deposition precision, compatibility with more complex geometries (e.g. cross finger), compatibility with large-area solar modules, reduced material consumptior

Patent document US2012/231576A1 discloses a printing head, and the method corresponding to its use, for printing a conductive grid line on a solar cell as front electrode. The nozzles on the printing head are aligned and spaced apart by the distance separating two adjacent lines such that all conductive lines can be printed simultaneously in one single pass.

### Summary

The object of the present application is to provide a method for forming crisscrossed conductive lines of a thin-film solar module, which is capable of depositing crisscrossed conductive lines in one machine/print direction. Furthermore, the method can be applied on a semitransparent front electrode layer to improve its electrical conductivity.

An embodiment of the present application provides a method for forming crisscrossed conductive lines of a thin-film solar module, the crisscrossed conductive lines being located on a surface of a front electrode layer of the thin-film solar module away from a substrate of the thin-film solar module, and comprising a G1 grid line group and a G2 grid line group perpendicular to each other, the method being performed by an inkjet printer comprising an inkjet print head moveable linearly with respect to the thin-film solar module, the inkjet print head comprising a plurality of nozzles arranged in a row, the plurality of nozzles comprising a first group of nozzles and a second group of nozzles, a distance between two adjacent nozzles in the first group of nozzles being the same as a distance between two adjacent G1 grid lines in the G1 grid line group, the second group of nozzles being distributed between adjacent nozzles of the first group of nozzles, the method comprising: forming a plurality of grooves on the surface of the front electrode layer away from the substrate; and during a linear motion of the inkjet print head with respect to the thin-film solar module in a direction perpendicular to the grooves, continuously depositing, by the first group of nozzles, conductive ink on the surface of the front electrode layer away from the substrate in the direction perpendicular to the grooves to form the G1 grid line group, and depositing, by the first group of nozzles and the second group of nozzles, the conductive ink into the grooves to form the G2 grid line group when the inkjet print head moves over the grooves in the direction perpendicular to the grooves.

In an embodiment of the present application, the thin-film solar module comprises the substrate and a plurality of solar cells in series; each of the plurality of solar cells comprises a back electrode layer, an absorber layer, a buffer layer and a front electrode layer, and P1, P2 and P3 structuring lines; the P1 structuring line extends through the back electrode layer, and is filled with a material of the absorber layer; the P2 structuring line extends through the buffer layer and the absorber layer, and is filled with a material of the front electrode layer; the P3 structuring line extends through the front electrode layer, the buffer layer and the absorber layer; each of the grooves is located on a corresponding P2 structuring line and parallel to the corresponding P2 structuring line.

In an embodiment of the present application, each G1 grid line in the G1 grid line group is formed by overlap of droplets of the conductive ink deposited by a same nozzle in the direction perpendicular to the grooves.

In an embodiment of the present application, each G2 grid line in the G2 grid line group is formed by inducing the flow of the conductive ink deposited into the grooves along the grooves by capillary force.

In an embodiment of the present application, the conductive ink is nanoparticular or metal-organic-complex precursor ink.

In an embodiment of the present application, a width of each of the grooves is less than a width of a corresponding P2 structuring line and is 20µm to 30µm.

In an embodiment of the present application, a width of each G1 grid line in the G1 grid line group is 40µm to100µm.

The method for forming crisscrossed conductive lines of a thin-film solar module according to the embodiment is a new inkjet printing process capable of self-aligned inkjet printing the G2 grid line group and the G1 grid line group in the same machine/printing direction. The method could be one-step approach for the metallization process of thin-film photovoltaic (PV) application. Comparing with conventional inkjet printing processes or other existing metal grid deposition technologies, the method for forming crisscrossed conductive lines of a thin-film solar module according to the embodiment shows various advantages in low circle time, high throughput, low CAPEX cost, and good line width control, better grid line aspect ratio and positioning accuracy, compatibility with more complex geometries, compatibility with large-area solar modules and reduced material consumption.

### Brief Description of the Drawings

In order to more clearly describe the technical solutions of the embodiments of the present disclosure or of the prior art, drawings that need to be used in embodiments and the prior art will be briefly described below. Obviously, the drawings provided below are for only some embodiments of the present disclosure. The same reference signs in the drawings indicate the same or similar elements.
Fig. 1 is a cross-section of a single thin-film solar module according to an embodiment of the present application;
Fig. 2 is a top view of a part of the single thin-film solar module as shown in Fig. 1;
Fig. 3 is a top view of a thin-film solar module with crisscrossed conductive lines according to an embodiment of the present application;
Fig. 4 is a flowchart of a method for forming crisscrossed conductive lines of a thin-film solar module according to an embodiment of the present application;
Fig. 5 is a diagram showing the flow of conductive ink in a groove by capillary force;
Fig. 6 is a diagram showing the forming of a G2 grid line by precisely depositing conductive ink into the groove;
Fig. 7 is a perspective view of depositing G1 grid lines in a machine direction by an inkjet print head according to an embodiment of the present application;
Fig. 8 is a top view of depositing G1 grid lines in a machine direction by an inkjet print head according to an embodiment of the present application;
Fig. 9 is a diagram showing the forming of the G1 grid lines;
Fig. 10 is a perspective view of depositing G2 grid lines in a machine direction by an inkjet print head according to an embodiment of the present application;
Fig. 11 is a diagram showing the forming of the G2 grid lines.

### Detailed Description

In order to make the objectives, technical solutions, and advantages of the present application clearer and more understandable, the present application will be described in detail below with reference to the appended drawings and embodiments. Obviously, the described embodiments are only some, and not all, of the embodiments of the present application. All other embodiments obtained based on the embodiments of the present disclosure by those skilled in the art fall into the scope of protection defined by the present disclosure.

A solar module manufactured by the thin-film PV technology can be referred to as a thin-film solar module. The thin-film solar module may include, for example, copper indium gallium selenium (CIGS) thin-film solar module, cadmium telluride (CdTe) thin-film solar module, organic photovoltaic (OPV) thin-film solar module, Perovskite thin-film solar module, dye-sensitized solar cell (DSSC) module, Heterojunction with Intrinsic Thin film (HJT) solar cell modules, and so on.

In general, a thin-film solar cell includes a back electrode layer, an absorber layer, a buffer layer/i-layer, and a front electrode layer in sequence. A thin-film solar module is typically formed by forming a plurality of thin-film solar cells on a large substrate and inter-connecting the thin-film solar cells in monolithic series. The specific structure and production method of various thin-film solar modules are known in the prior art, and thus are not introduced in detail.

The individual layers in a thin-film solar cell are interconnected, as shown in Fig.1. These layers are separated by P1, P2 and P3 structuring lines, respectively. The P1 structuring line and P3 structuring line insulate the back electrode layer and the front electrode layer, and the P2 structuring line serves as an electrical contact between the back electrode layer and the front electrode layer for serial connection of two neighboring cells. Since the structuring area of the P1, P2 and P3 structuring lines does not generate electricity, it usually refers to as the "dead area", see Fig. 2.

To optimize the power conversion efficiency of the solar cell, one approach is often considered, e.g. increasing the transmission of the front electrode layer of the solar cell by reducing the thickness of the front electrode layer and further the photo current generated. However, it will lead to an increase in the sheet resistance of the front electrode layer, causing ensuing conduction losses. To reduce such conduction losses in the front electrode layer, highly conductive narrow metal grid lines (which are referred to as the first type of grid lines) can be applied on the front electrode layer to improve related electrical conductivity, which refers to as a metallization process in the solar module production. In the metallization process, the first type of grid lines is deposited transversely or in the direction perpendicular to the P1/P2/P3 structuring lines on the top of the front electrode layers of the solar cells at periodic intervals. Further, the first type of grid lines is deposited continuously over the front electrode layers of the solar cells. The P3 structuring line interrupts the first type of grid lines to prevent a short circuit between the front electrodes of one cell and its neighboring cell.

The first type of grid lines can reduce the conduction losses of the front electrode layer. However, the first type of grid lines also lead to an increase in the dead area due to the shading of the first type of grid lines, and further cause additional optical losses. Besides, the application of the first type of grid lines also can lead to a concentrated current at an end of a cell. In the case of a monolithic interconnected cell, the current collected at the first type of grid lines flows to an end of the cell and needs to be evenly distributed at the beginning of the next cell. Otherwise, further conduction losses in the front and back electrode layers will arise.

Therefore, an additional grid line, which is referred to as the second type of grid line, is deposited within the dead area and perpendicular to the first type of grid line. Here, the first type of grid line is denoted as G1, and is perpendicular to the P2 structuring line; the second type of grid line is denoted as G2, and is deposited exactly on the P2 structuring line and parallel to the P2 structuring line. The intention of depositing the G2 grid line is to evenly distribute the current and reduce electrical loss along P2 structuring line interconnect between two G1 grid lines, which is caused by current distribution from the G1 grid lines raised at the beginning of the next cell. Since the G2 gird line is placed in the dead area, it will not cause additional optical loss by shading. Besides, the G2 grid line can improve the generation of photo current, which is contributed by the light reflection at the G2 grid line onto the back of the over-layer/front glass and further into the active cell area.

Embodiments of the present application provide a method for forming crisscrossed conductive lines of a thin-film solar module, which is capable of depositing crisscrossed conductive lines in one machine/print direction. Furthermore, embodiments of the present application provides an inkjet printer for forming crisscrossed conductive lines of a thin-film solar module, which can perform the method for forming crisscrossed conductive lines of a thin-film solar module.

Fig. 1 is a cross-section of a single thin-film solar cell 1 according to an embodiment of the present application. The thin-film solar cell 1 includes a back electrode layer 12, an absorber layer 13, a buffer layer/i-layer 14, a front electrode layer 15, a P1 structuring line, a P2 structuring line and a P3 structuring line. The back electrode layer 12 is disposed on a substrate 11. The absorber layer 13 is disposed on the back electrode layer 12. The buffer layer/i-layer 14 is disposed on the absorber layer 13. The front electrode layer 15 is disposed on the buffer layer/i-layer 14.

The back electrode layer 12, the absorber layer 13, the buffer layer/i-layer 14 and the front electrode layer 15 are separated by the P1, P2 and P3 structuring lines. The P1 structuring line extends through the back electrode layer 12, and is filled with a material of the absorber layer 13. The P2 structuring line extends through the buffer layer/i-layer 14 and the absorber layer 13, and is filled with a material of the front electrode layer 15. The P3 structuring line extends through the front electrode layer 15, the buffer layer/i-layer 14 and the absorber layer 13. The P1 structuring line and the P3 structuring line insulate the back electrode layer 12 and the front electrode layer 15, and the P2 structuring line serves as an electrical contact between the back electrode layer 12 and the front electrode layer 15 for serial connection of two neighboring cells. Since the structuring area of the P1, P2 and P3 structuring lines does not generate electricity, it usually refers to as the "dead area", see Fig. 2.

Referring to Fig. 1, the crisscrossed conductive lines are located on a surface of the front electrode layer 15 away from the substrate. The crisscrossed conductive lines include a G1 grid line and a G2 grid line.

Fig. 2 is a top view of a part of the single thin-film solar module 1 as shown in Fig. 1. Referring to Figs. 1 and 2, the G1 grid line is perpendicular to the P2 structuring line. The G2 grid line is exactly on the P2 structuring line and parallel to the P2 structuring line. The G1 grid line is perpendicular to the G2 grid line. The G2 grid line is located in the dead area. Since the G2 gird line is placed in the dead area, it will not cause additional optical loss by shading. Furthermore, the G2 grid line can improve the generation of photo current, which is contributed by the light reflection at the G2 grid line onto the back of the over-layer/front glass and further into the active cell area.

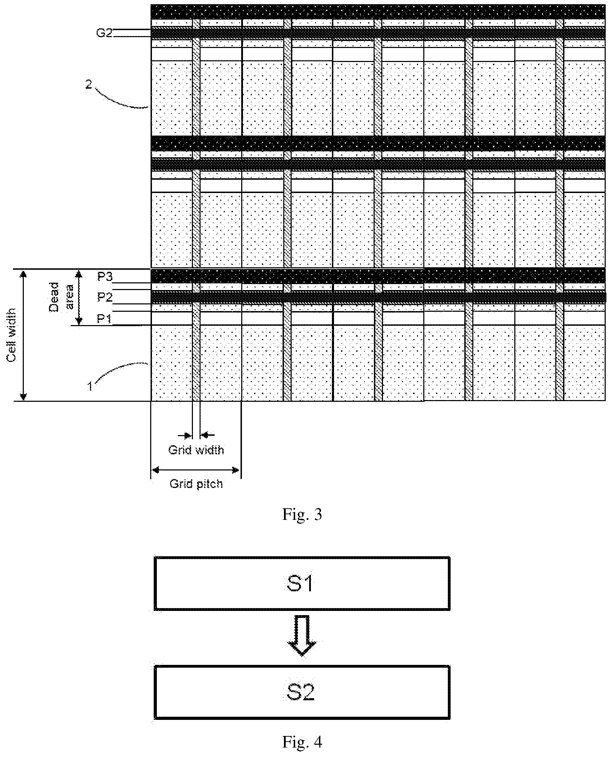

Fig. 3 is a top view of a thin-film solar module 2 having crisscrossed conductive lines according to an embodiment of the present application. The thin-film solar module 2 may include a plurality of solar cells in series on the substrate. For example, as shown in Fig. 3, the thin-film solar module 2 includes three solar cells in series. The crisscrossed conductive lines are located on the surface of the front electrode layer of the thin-film solar module 2 away from the substrate, and include a G1 grid line group and a G2 grid line group perpendicular to one another. The front electrode layer of the thin-film solar module 2 consists of front electrode layers of the plurality of solar cells in series. The G1 grid line group includes a plurality of G1 grid lines separated from one another. The G2 grid line group includes a plurality of G2 grid lines separated from one another. In an embodiment, a distance between two adjacent G1 grid lines in the G1 grid line group may be 100µm~200µm.

As shown in Fig. 3, each thin-film solar cell 1 in the thin-film solar module 2 has a G2 grid line located on a corresponding P2 structuring line and parallel to the P2 Structuring line, and G1 grid lines separated from each other.

Fig. 4 is a flowchart of a method for forming crisscrossed conductive lines of a thin-film solar module according to an embodiment of the present application. The method can be achieved by an inkjet printing technology. The method may be performed by an inkjet printer according to an embodiment of the preset application, and may include steps S1 and S2.

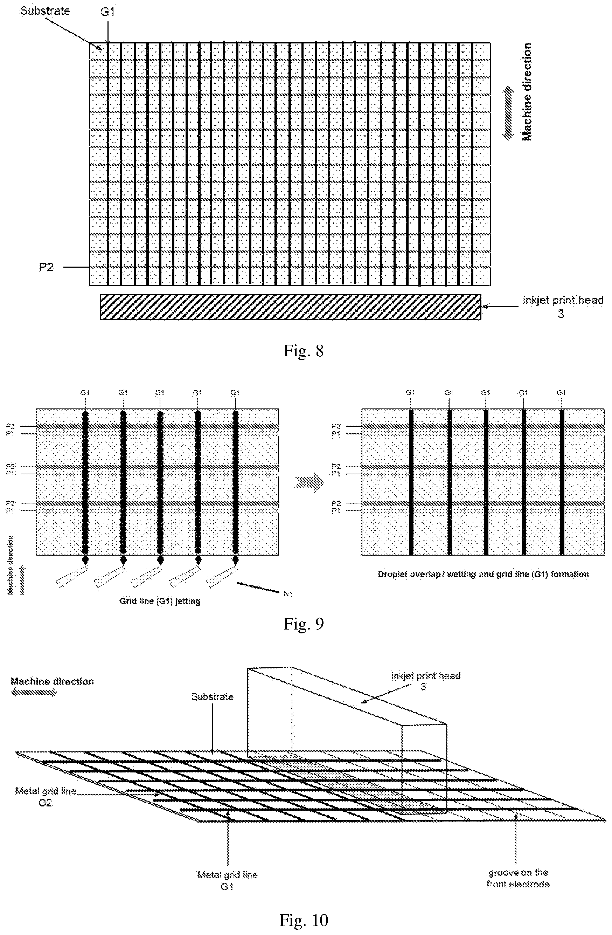

In an embodiment, the inkjet printer may include at least one inkjet print head 3 moveable linearly with respect to the thin-film solar module. Each inkjet print head 3 includes a plurality of nozzles arranged in a row. The plurality of nozzles includes a first group of nozzles N1 and a second group of nozzles N2, as shown in Figs. 9 and 10. A distance between two adjacent nozzles in the first group of nozzles N1 is the same as a distance between two adjacent G1 grid lines in the G1 grid line group, which is equal to a grid pitch. The second group of nozzles N2 are distributed between adjacent nozzles of the first group of nozzles N1.

At step S1, a plurality of grooves are formed on the surface of the front electrode layer away from the substrate.

The grooves on the front electrode layer surface are formed by the following processes. As shown in Fig.1, the buffer/i-layer 14 and absorber layer 13 reveal a groove for forming a P2 structuring line, called P2-groove. The P2-groove extends through the buffer/i-layer 14 and absorber layer 13 to the back electrode by laser or mechanical needle scribing. Then, the front electrode layer is deposited over the entire CIGS layer stack. Accordingly, the P2-groove is filled with the material of the front electrode layer. A further groove structure, that is, a groove for forming the G2 grid line, is formed at a position corresponding to the P2-groove on the surface of the front electrode layer away from the substrate by the laser or mechanical needle scribing.

At step S2, during a linear motion of the inkjet print head with respect to the thin-film solar module in a direction perpendicular to the grooves, conductive ink is continuously deposited by the first group of nozzles on the surface of the front electrode layer away from the substrate in the direction perpendicular to the grooves to form the G1 grid line group, and conductive ink is deposited by the first group of nozzles and the second group of nozzles into the grooves to form the G2 grid line group when the inkjet print head moves over the grooves in the direction perpendicular to the grooves.

In an embodiment, each of the grooves is located on a corresponding P2 structuring line and parallel to the P2 structuring line. The width of the groove may be 20µm ~30µm.

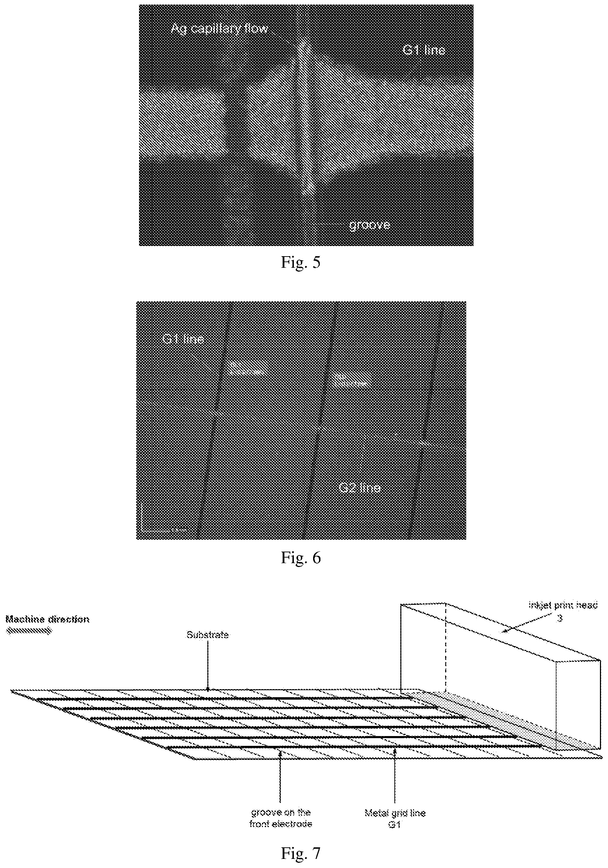

The researcher found that after ink droplets are placed into the groove, the ink droplets will flow in the groove by capillary force, as shown in Fig. 5. The width of the groove is generally 20µm ~30µm, and is far below the diameter of ink droplets of 40µm~100µm. Once ink droplets jetted in a machine/printing direction can be placed precisely into the groove, they can overcome the spacing of few hundred micrometers between the droplets to form a continuous G2 grid line within the groove by self-alignment, as shown in Fig.6. Otherwise, if these droplets are deposited next to the groove, they will only form discrete dots causing additional shunts or optical losses, when they are in the active cell area of the solar module. The machine/printing direction is a direction in which the inkjet print head moves linearly with respect to the thin-film solar module. The direction is perpendicular to the groove on the front electrode layer, that is, perpendicular to the P2 structuring line.

In an embodiment, the conductive ink for forming the G1 grid line and the G2 grid line may be nanoparticular or metal-organic-complex precursor inks. The main solid contents used in the ink may be Ag, Cu, Al, or other conductive nanoparticles or their derivatives.

Fig. 5 is a diagram showing the flow of conductive ink in a groove by capillary force. Fig. 6 is a diagram showing the forming of a G2 grid line by precisely depositing conductive ink into the groove. As shown in Fig. 5, after the conductive ink for printing the G2 grid line is deposited into the groove, the conductive ink flows along the groove by means of the capillary force, which can overcome the spacing of few hundred micrometers between the droplets to form a continuous G2 grid line within the groove by self-alignment. In this way, the G2 grid lines can be formed during the printing of the G1 grid lines in the machine/printing direction. In other words, the inkjet print head may deposit the G1 grid line group and the G2 grid line group in one machine/printing direction.

In an embodiment, the G1 grid line group and the G2 grid line group are possible to be printed in one-step. Alternatively, the G1 grid line group and the G2 grid line group may be also printed separately. The machine/printing direction will remain unchanged, no matter of the sequence of printing the G1 grid line group and the G2 grid line group. This can enable saving in space, CAPEX cost and circle time.

In an embodiment, the G1 grid line group and the G2 grid line group may be printed separately in the same machine/printing direction. For example, the G1 grid line group is first deposited, and then the G2 grid line group is deposited after the deposition of the G1 grid line group is completed. Alternatively, the G2 grid line group is first deposited, and then the G1 grid line group is deposited after the deposition of the G2 grid line group is completed. An example process of first depositing the G1 grid line group and then depositing the G2 grid line group will be introduced as follows.

Figs. 7-11 show a process of first depositing the G1 grid line group and then depositing the G2 grid line group by an inkjet printer for forming crisscrossed conductive lines of a thin-film solar module according to an embodiment of the present application.

Referring to Figs. 7-11, an embodiment of the present application further provides an inkjet printer for forming crisscrossed conductive lines of a thin-film solar module. In the embodiment, the inkjet printer may comprise a controller (not shown) and at least one inkjet print head 3 moveable linearly with respect to the thin-film solar module. Each of the at least one inkjet print head 3 comprises a plurality of nozzles arranged in a row. The plurality of nozzles comprises a first group of nozzles N1 and a second group of nozzles N2, as shown in Figs. 9 and 10. A distance between two adjacent nozzles in the first group of nozzles N1 is the same as a distance between two adjacent G1 grid lines in the G1 grid line group. The second group of nozzles are distributed between adjacent nozzles of the first group of nozzles.

The controller controls the at least one inkjet print head 3 to move linearly with respect to the thin-film solar module in a direction perpendicular to the grooves, and controls the first group of nozzles N1 and the second group of nozzles N2 in each of the at least one inkjet print head 3 to deposit conductive ink on the surface of the front electrode layer away from the substrate to form the G1 grid line group and the G2 grid line group.

The first group of nozzles N1 in each of the at least one inkjet print head 3 are controlled by the controller to continuously deposit the conductive ink in the direction perpendicular to the grooves.

The second group of nozzles N2 in each of the at least one inkjet print head 3 are controlled by the controller to deposit the conductive ink into the grooves when the inkjet print head moves over the grooves in the direction perpendicular to the grooves.

Fig. 7 is a perspective view of depositing G1 grid lines in a machine direction by an inkjet print head according to an embodiment of the present application. Fig. 8 is a top view of depositing G1 grid lines in a machine direction by an inkjet print head according to an embodiment of the present application. Fig. 9 is a diagram showing the forming of the G1 grid lines.

Referring to Figs. 7 and 8, the inkjet print head moves with respect to the thin-film solar module in a machine direction to deposit the G1 grid line group on the top of the front electrode layer (or other interfacial layers) in the thin-film solar module, that is, on the surface of the front electrode layer away from the substrate. In general, the G1 grid lines will be deposited continuously in the direction perpendicular to P2 structuring lines, that is, the machine direction. In the embodiment, the G1 grid line group is deposited by the inkjet print head on the entire thin-film solar module in one-step. This can reduce production circle time and increase production throughput.

Referring to Fig. 9, the formation of each G1 grid line in the G1 grid line group can be realized by overlap of deposited droplets in the machine direction, that is, in the direction perpendicular to P2 structuring lines. The critical size of droplets for forming a single G1 grid line may be 10~25 pl, in order to form a narrow G1 grid line in a width of 40~100µm. Referring to Fig. 9, the first group of nozzles N1 in the inkjet print head 3 are used to deposit droplets for forming the G1 grid line group. The distance between two adjacent nozzles in the first group of nozzles N1 is the same as the distance between two adjacent G1 grid lines in the G1 grid line group. During the printing of the G1 grid line group, the second group of nozzles N2 in the inkjet print head 3 are inactive, that is, do not deposit the droplets.

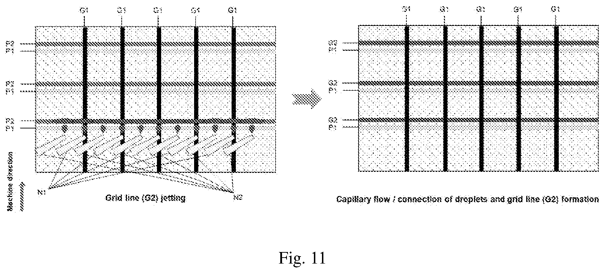

Fig. 10 is a perspective view of depositing G2 grid lines in a machine direction by an inkjet print head according to an embodiment of the present application. Fig. 11 is a diagram showing the forming of the G2 grid lines.

Referring to Fig. 10, the inkjet print head moves with respect to the thin-film solar module with the G1 grid line group in the same machine direction as the G1 grid line group, that is, in the direction perpendicular to the P2 structuring lines, to deposit the G2 grid line group on the top of the front electrode layer (or other interfacial layers) in the thin-film solar module, that is, on the surface of the front electrode layer away from the substrate. In the embodiment, the G2 grid line group is deposited by the inkjet print head on the entire thin-film solar module in one-step. This can reduce production circle time and increase production throughput.

Referring to Fig. 11, in the embodiment, the second group of nozzles N2 of the inkjet print head are distributed between adjacent nozzles of the first group of nozzles. During the printing of each G2 grid line in the G2 grid line group, when the inkjet print head moves over a groove in the front electrode layer in the direction perpendicular to the groove, all of nozzles (including the first group of nozzles N1 and the second group of nozzles N2) in the inkjet print head deposit the conductive ink into the groove to form the G2 grid line. After the conductive ink enters into the groove, the conductive ink flows along the groove by means of capillary force, to from the G2 grid line. In this way, the G2 grid line will stay in the groove and not across the edges of the P1 and P3 structuring lines. This can reduce the shunting or additional optical loss issues.

In an embodiment, the G1 grid line group and the G2 grid line group may be formed in one-step in the machine/printing direction. Specifically, during the motion of the inkjet print head with respect to the thin-film solar module in the machine/printing direction, i.e., the direction perpendicular to the P2 structuring lines, the controller controls the first group of nozzles N1 in the inkjet print head 3 to continuously deposit the conductive ink, and controls the second group of nozzles N2 in the inkjet print head 3 to deposit the conductive ink only when the inkjet print head moves over the grooves in the front electrode layer. In this way, the G1 grid line group and the G2 grid line group can be formed in one-step.

In an embodiment, the printing of G1 or G2 grid lines may be single or multiple passes, in order to achieve the optimal line width and height for the best device performance in the solar modules.

In an embodiment, after the G1 grid line group and the G2 grid line group are deposited on the surface of the front electrode layer (or other interface layers) in the thin-film solar module away from the substrate by the inkjet printing technology, the deposited G1 grid line group and G2 grid line group are cured/annealed to be converted into bulk material without or with very less organic residues within the grain structures. By this means, good electrical conductivity can be achieved. Thereby, the curing temperature for the deposited G1 grid line group and G2 grid line group may be 120~250°C. The curing process may be implemented via various convective ovens (such as batch, conveyor, or hybrid hot air ovens, etc.), or radiative heating aggregates (infrared emitter, UV curer, microwave oven, etc.), or conductive hot plate.

Additionally, the inkjet printing of the G2 grid line group in same printing/machine direction as the printing/machine of the G1 Grid line group, through capillary flow induced self-alignment, is not possible to be realized by other special contactless jetting technologies, such as dispensing or aerosol jetting.

In comparison to the inkjet printing (discrete as dot on dot via piezo crystal) in the present application, the dispensing is a continuous jetting method via hydraulic pressure to inject liquid ligaments in a typical diameter from 20 micrometers to few hundred micrometers. In the case of using multi-nozzle dispensing, a dimension of a single nozzle unit of the dispensing is in millimeter range (5~10mm), comparing with the nozzle spacing (100~200µm) in the inkjet printing. In addition, the viscosity of applied dispensing conductive metal particular ink is about 100~1000 times of the ones of inkjet conductive inks. Therefore, it is almost impossible to form the G2 grid line in the same printing direction as the printing of the G1 grid line by inducing the flow of the dispensing conductive metal particular ink in the G2 groove through capillary force. To note, it is only possible to deposit the G2 grid line by a single nozzle dispensing in a direction perpendicular to the printing direction of the G1 grid line.

The aerosol jetting is a jetting method using ink aerosol generated by ultrasonic or pneumatic atomization. This method can generate grid lines having a typical width of 5~20µm. In this method, it is only possible to print the G2 grid lines with a single aerosol jetting nozzle in a direction perpendicular to the printing direction of the G1 grid lines. For multi-nozzle aerosol jetting, its nozzle spacing is similar as the nozzle spacing of the dispensing. The aerosol jetting does not jet droplets (in picoliters in the inkjet printing) or ligaments, but does jet ink aerosols. Therefore, it is impossible to form the G2 grid line in the same printing direction as the printing direction of the G1 grid line by inducing the flow of the ink aerosol in the G2 groove through capillary force.

The method and the inkjet printer for forming crisscrossed conductive lines of a thin-film solar module according to the embodiments of the present application can have the following advantages. The front electrode layer having the G2 grid lines can be further drastically enhanced in terms of electrical conductivity. The inherent shape of the groove located over the structuring line and parallel to the P2 structuring line helps to restrain the width of the G2 gird line. The G2 grid line having a very narrow width can be achieved depending on the width of the groove, which can be hardly achieved on a normal substrate surface by the inkjet printing. Since the G2 grid line has the narrow width, the possibility of the G2 grid line exceeding the active area will be further reduced, thereby reducing the shunting or optical losses. In addition, by the method and the inkjet printer of the present application, the G2 grid lines and the G1 grid lines can be printed in the same machine/printing direction, which can save a lot of CAPEX cost in terms of equipment design, and improve the production throughput.

Compared to vacuum coating through mask, the G1 grid line group and the G2 grid line group will be directly deposited onto the target surface by the inkjet printing method without unnecessary waste on working chamber or masks. Compared to the screen printing method, the inkjet printing method is much more flexible in adjusting the grid line pitch or pattern design. And, the inkjet printing method has no limitation in the size of the thin-film solar module. Since the inkjet printing method is a digital printing method, it will have no large deviation of a printing width and shape in a certain area for a large substrate caused by limited mechanical properties of a screen mesh in the case of the screen printing method. The disposition accuracy of metal grid lines formed by the inkjet printing method is also much higher than those conventional printing methods. The inkjet printing method enables the ink jetted G2 grid lines exactly into the grooves, which avoids the shunting or additional optical losses caused by inaccurate positioning of the G2 grid lines.

The inkjet printer and method for forming crisscrossed conductive lines of a thin-film solar module according to the embodiments are a new inkjet process capable of self-aligned inkjet printing the G2 grid line group and the G1 grid line group in the same machine/printing direction. Comparing with conventional inkjet processes or other existing metal grid deposition technologies, the inkjet printer and method for forming crisscrossed conductive lines of a thin-film solar module according to the embodiment show various advantages in low circle time, high throughput, low CAPEX cost, and good line width control, better grid line aspect ratio and positioning accuracy, compatibility with more complex geometries, compatibility with large-area solar modules and reduced material consumption.

## Claims

1. A method for forming crisscrossed conductive lines of a thin-film solar module, the crisscrossed conductive lines being located on a surface of a front electrode layer of the thin-film solar module away from a substrate of the thin-film solar module, and comprising a G1 grid line group and a G2 grid line group perpendicular to each other, the method being performed by an inkjet printer comprising an inkjet print head moveable linearly with respect to the thin-film solar module, the inkjet print head comprising a plurality of nozzles arranged in a row, the plurality of nozzles comprising a first group of nozzles and a second group of nozzles, a distance between two adjacent nozzles in the first group of nozzles being the same as a distance between two adjacent G1 grid lines in the G1 grid line group, the second group of nozzles being distributed between adjacent nozzles of the first group of nozzles,
wherein the method comprises:
forming a plurality of grooves on the surface of the front electrode layer away from the substrate; and
during a linear motion of the inkjet print head with respect to the thin-film solar module in a direction perpendicular to the grooves, continuously depositing, by the first group of nozzles, conductive ink on the surface of the front electrode layer away from the substrate in the direction perpendicular to the grooves to form the G1 grid line group, and depositing, by the first group of nozzles and the second group of nozzles, the conductive ink into the grooves to form the G2 grid line group when the inkjet print head moves over the grooves in the direction perpendicular to the grooves.

2. The method of claim 1, wherein the thin-film solar module comprises the substrate and a plurality of solar cells in series; each of the plurality of solar cells comprises a back electrode layer, an absorber layer, a buffer layer and a front electrode layer, and P1, P2 and P3 structuring lines; the P1 structuring line extends through the back electrode layer, and is filled with a material of the absorber layer; the P2 structuring line extends through the buffer layer and the absorber layer, and is filled with a material of the front electrode layer; the P3 structuring line extends through the front electrode layer, the buffer layer and the absorber layer; each of the grooves is located on a corresponding P2 structuring line and parallel to the corresponding P2 structuring line.

3. The method of claim 1, wherein each G1 grid line in the G1 grid line group is formed by overlap of droplets of the conductive ink deposited by a same nozzle in the direction perpendicular to the grooves.

4. The method of claim 1, wherein each G2 grid line in the G2 grid line group is formed by inducing the flow of the conductive ink deposited into the grooves along the grooves by capillary force.

5. The method of claim 1, wherein the conductive ink is nanoparticular or metal-organic-complex precursor ink.

6. The method of claim 1, wherein a width of each of the grooves is less than a width of a corresponding P2 structuring line and is 20µm to 30µm.

7. The method of claim 1, wherein a width of each G1 grid line in the G1 grid line group is 40µm to100µm.

## Patentansprüche

1. Verfahren zum Herstellen kreuzförmiger Leiterbahnen eines Dünnschichtsolarmoduls, wobei sich die kreuzförmigen Leiterbahnen auf einer Oberfläche einer vorderen Elektrodenschicht des Dünnschichtsolarmoduls entfernt von einem Substrat des Dünnschichtsolarmoduls befinden, und umfassend eine Gitterliniengruppe G1 und eine Gitterliniengruppe G2, die senkrecht zueinander sind, wobei das Verfahren von einem Tintenstrahldrucker durchgeführt wird, der einen Tintenstrahl-Druckkopf umfasst, der in Bezug auf das Dünnschichtsolarmodul linear bewegbar ist, wobei der Tintenstrahl-Druckkopf eine Vielzahl an Düsen umfasst, die in einer Reihe angeordnet sind, wobei die Vielzahl an Düsen eine erste Gruppe von Düsen und eine zweite Gruppe von Düsen umfasst, eine Distanz zwischen zwei benachbarten Düsen in der ersten Gruppe von Düsen gleich einer Distanz zwischen zwei benachbarten Gitterlinien G1 in der Gitterliniengruppe G1 ist, die zweite Gruppe von Düsen zwischen benachbarten Düsen der ersten Gruppe von Düsen verteilt ist,
wobei das Verfahren Folgendes umfasst:
Herstellen einer Vielzahl von Rillen auf der Oberfläche der vorderen Elektrodenschicht entfernt von dem Substrat; und
während einer linearen Bewegung des Tintenstrahl-Druckkopfes in Bezug auf das Dünnschichtsolarmodul in eine Richtung, die senkrecht zu den Rillen ist, kontinuierliches Aufbringen, durch die erste Gruppe von Düsen, von leitfähiger Tinte auf die Oberfläche der vorderen Elektrodenschicht entfernt von dem Substrat in die Richtung, die senkrecht zu den Rillen ist, zum Herstellen der Gitterliniengruppe G1 und Aufbringen, durch die erste Gruppe von Düsen und die zweite Gruppe von Düsen, der leitfähigen Tinte in die Rillen zum Herstellen der Gitterliniengruppe G2, wenn sich der Tintenstrahl-Druckkopf über die Rillen in die Richtung bewegt, die senkrecht zu den Rillen ist.

2. Verfahren nach Anspruch 1, wobei das Dünnschichtsolarmodul das Substrat und eine Vielzahl an Solarzellen in Reihe umfasst; wobei jede der Vielzahl der Solarzellen eine hintere Elektrodenschicht, eine Absorberschicht, eine Pufferschicht und eine vordere Elektrodenschicht und strukturierende Linien P1, P2 und P3 umfasst; wobei sich die strukturierende Linie P1 durch die hintere Elektrodenschicht erstreckt und mit einem Material der Absorberschicht gefüllt ist; sich die strukturierende Linie P2 durch die Pufferschicht und die Absorberschicht erstreckt und mit einem Material der vorderen Elektrodenschicht gefüllt ist; sich die strukturierende Linie P3 durch die vordere Elektrodenschicht, die Pufferschicht und die Absorberschicht erstreckt; wobei sich jede der Rillen auf einer entsprechenden strukturierenden Linie P2 befindet und parallel zu der entsprechenden strukturierenden Linie P2 ist.

3. Verfahren nach Anspruch 1, wobei jede Gitterlinie G1 in der Gitterliniengruppe G1 hergestellt wird durch Überlappen von Tropfen der leitfähigen Tinte, die von einer selben Düse in die Richtung aufgebracht wird, die senkrecht zu den Rillen ist.

4. Verfahren nach Anspruch 1, wobei jede Gitterlinie G2 in der Gitterliniengruppe G2 hergestellt wird durch Induzieren des Flusses der leitfähigen Tinte, die durch Kapillarkraft entlang der Rillen in die Rillen aufgebracht wird.

5. Verfahren nach Anspruch 1, wobei es sich bei der leitfähigen Tinte um nanopartikuläre Tinte oder Tinte mit einem metallorganischen Komplex als Vorläufer handelt.

6. Verfahren nach Anspruch 1, wobei eine Breite jeder der Rillen geringer ist als eine Breite einer entsprechenden strukturierenden Linie P2 und zwischen 20 µm und 30 µm beträgt.

7. Verfahren nach Anspruch 1, wobei eine Breite jeder Gitterlinie G1 in der Gitterliniengruppe G1 40 µm bis 100 µm beträgt.

## Revendications

1. Procédé de formation de lignes conductrices entrecroisées d'un module solaire à film mince, les lignes conductrices entrecroisées étant situées sur la surface d'une couche d'électrode avant du module solaire à film mince à l'écart d'un substrat du module solaire à film mince, et comprenant un groupe de lignes de grille G1 et un groupe de lignes de grille G2 perpendiculaires l'un à l'autre, le procédé étant mis en oeuvre par une imprimante à jet d'encre comprenant une tête d'impression à jet d'encre mobile linéairement par rapport au module solaire à film mince, la tête d'impression à jet d'encre comprenant une pluralité de buses disposées en rangée, la pluralité de buses comprenant un premier groupe de buses et un second groupe de buses, la distance entre deux buses adjacentes du premier groupe de buses étant identique à la distance entre deux lignes de grille G1 adjacentes du groupe de lignes de grille G1, le second groupe de buses étant réparti entre les buses adjacentes du premier groupe de buses,
dans lequel le procédé comprend :
la formation d'une pluralité de rainures sur la surface de la couche d'électrode avant à l'écart du substrat ; et
lors d'un mouvement linéaire de la tête d'impression à jet d'encre par rapport au module solaire à couche mince dans une direction perpendiculaire aux rainures, le dépôt continuel, par le premier groupe de buses, de l'encre conductrice sur la surface de la couche d'électrode avant à l'écart du substrat dans la direction perpendiculaire aux rainures pour former le groupe de lignes de grille G1, et le dépôt, par le premier groupe de buses et le second groupe de buses, de l'encre conductrice dans les rainures pour former le groupe de lignes de grille G2 lorsque la tête d'impression à jet d'encre se déplace sur les rainures dans la direction perpendiculaire aux rainures.

2. Procédé selon la revendication 1, dans lequel le module solaire à couche mince comprend le substrat et une pluralité de cellules solaires en série ; chacune de la pluralité de cellules solaires comprend une couche d'électrode arrière, une couche absorbante, une couche tampon et une couche d'électrode avant, et des lignes de structuration P1, P2 et P3 ; la ligne de structuration P1 s'étend à travers la couche d'électrode arrière, et est remplie d'un matériau de la couche absorbante ; la ligne de structuration P2 s'étend à travers la couche tampon et la couche absorbante, et est remplie d'un matériau de la couche d'électrode avant ; la ligne de structuration P3 s'étend à travers la couche d'électrode avant, la couche tampon et la couche absorbante ; chacune des rainures est située sur une ligne de structuration P2 correspondante et parallèle à la ligne de structuration P2 correspondante.

3. Procédé selon la revendication 1, dans lequel chaque ligne de grille G1 dans le groupe de lignes de grille G1 est formée par chevauchement de gouttelettes de l'encre conductrice déposées par une même buse dans la direction perpendiculaire aux rainures.

4. Procédé selon la revendication 1, dans lequel chaque ligne de grille G2 dans le groupe de lignes de grille G2 est formée en induisant l'écoulement de l'encre conductrice déposée dans les rainures le long des rainures par force capillaire.

5. Procédé selon la revendication 1, dans lequel l'encre conductrice est une encre précurseur nanoparticulaire ou à complexe organométallique.

6. Procédé selon la revendication 1, dans lequel la largeur de chacune des rainures est inférieure à la largeur d'une ligne de structuration P2 correspondante et est comprise entre 20 µm et 30 µm.

7. Procédé selon la revendication 1, dans lequel la largeur de chaque ligne de grille G1 dans le groupe de lignes de grille G1 est de 40 µm à 100 µm.
